# EUROPEAN PATENT SPECIFICATION

(11) **EP 0 319 121 B1**
(45) Date of publication and mention of the grant of the patent: **04.03.1992**
(21) Application number: 88307328.0
(22) Date of filing: 08.08.1988
(51) Int. Cl.: C30B 35/00, H01L 21/205, H01L 21/203

(54) **Apparatus for producing semiconductors**
Apparat zur Produktion von Halbleitern
Appareil pour la fabrication des semi-conducteurs

(30) Priority: 30.11.1987 JP 304204/87; 30.11.1987 JP 304210/87
(43) Date of publication of application: 07.06.1989
(73) Proprietor: DAIDOUSANSO CO., LTD., Osaka-shi Osaka 542 (JP)
(72) Inventor: Yoshino, Akira, Osakasayama-shi Osaka 589 (JP); Ohmori, Yoshinori, Osaka 591 (JP); Ohnishi, Toshiharu, Tondabayashi-shi Osaka 584 (JP)
(74) Representative: Marlow, Nicholas Simon

(56) References cited:
- EP-A- 0 259 759
- PATENT ABSTRACTS OF JAPAN vol.9, no. 21 (C-263)(1744), 29th January 1985; & JP-A-59 170 000
- PATENT ABSTRACTS OF JAPAN vol.11, no. 127 (E-501(2574) 21st April 1987; & JP-A-61 272918
- JAPANESE JOURNAL OF APPLIED PHYSICS 26 (1987) March, no. 3, part 1, pages 419-422, New York, U.S.A.; K. KIMURA et al.: " Molecular Beam Epitaxial Growth of GaAs Using Triethylgallium and As4 "
- JOURNAL OF CRYSTAL GROWTH 84 (1987) August, no. 2, pages 191-195, Amsterdam, The Netherlands; C. Blaauw et al.: " A Gas Mixing Device For Mocvd "

## Description

This invention relates to an apparatus for producing semiconductors of the type in which Group III-V compound semiconductor layers are deposited in a vacuum chamber, such as a vacuum chemical epitaxy (VCE) system.

In recent years, the demand for compound semiconductors especially Group III-V compounds (e.g. GaAs) has been growing because of their being superior in performance characteristics to the conventional silicon semiconductors. For the production of such Group III-V compound semiconductors, there are known, among others, the so-called molecular beam epitaxy (MBE) process which comprises causing atoms required for a compound to be epitaxy grown to evaporate from a solid material using a heat gun and causing them to collide, in the molecular beam form, against a substrate in an ultrahigh vacuum to thereby cause growth of a film of said material on said substrate, and the so-called metal organic chemical vapor desposition (MOCVD) process which comprises introducing the vapor of a methyl-metal or ethyl-metal compound into a reaction chamber at atmospheric pressure or under reduced pressure by means of a carrier gas such as H₂, allowing said vapor to mix with a Group V metal hydride and allowing the reaction therebetween to take place on a heated substrate for crystal growth.

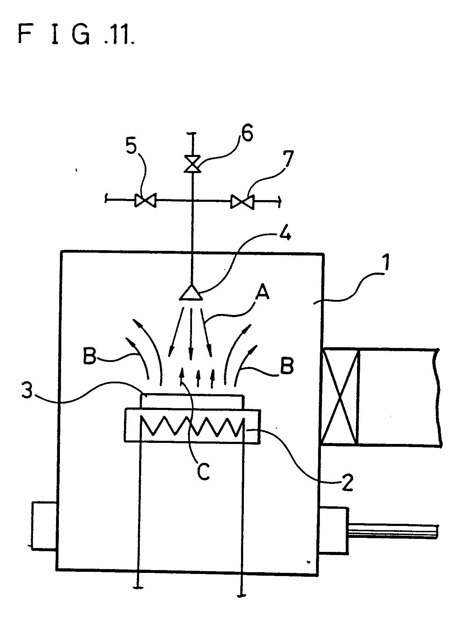

However, the MBE process has a problem in that it is not suited for large-scale production, hence can hardly meet the needs of the market. The MOCVD process also has a problem in that the reactant gases are expensive and because of the growth mechanism, the efficiency of utilization of reactant gases is low, although said process is higher in production capacity than the above-mentioned MBE process. It is therefore difficult to employ the MOCVD process for the production of semiconductors for use in other fields than some special fields where high costs do not matter. Furthermore, since a large quantity of unreacted gas, which is toxic, is produced because of the efficiency of reactant gas utilization being low, as mentioned above, and since a carrier gas is used for gasifying and carrying the Group III compound, which has a low vapor pressure, and this constitutes an additional waste gas portion, a toxic waste gas is discharged in large quantities, and this fact leads to waste gas disposal problems. Apparatus so far in use for such MOCVD process can be schematically illustrated by Fig. 11. Thus, a substrate 3 is mounted on a heater 2 disposed in a vacuum chamber 1, and a gaseous compound mixture for semiconductor deposition is fed toward the substrate 3 the directions indicated by the arrows A from a nozzle 4 disposed in the upper part of said vacuum chamber 1. In such apparatus, the vacuum chamber 1, which has a large capacity, is filled with a gaseous compound (reactant gas) mixture for each treatment run and, after treatment, the gaseous compound mixture is discharged as a waste gas. The waste gas contains unreacted gases, which have not been involved in semiconductor deposition, in large quantities and, accordingly, the reactant gas utilization efficiency is low. In the above-mentioned apparatus, the substrate 3 is placed on the heater 2 and heated from the under surface. Thermal convection thus takes place over the substrate, as shown by the arrows B, and heat is dissipated from the substrate 3 heated by the heater 2 to the vicinity of the upper surface of the substrate 3, as shown by the arrows C. As a result, the flow of the gaseous compound mixture fed from the nozzle 4 is disturbed by the forcing-up effect of the above-mentioned thermal convection current (arrows B) and heat dissipated (arrows C), so that uniform film growth on the upper surface of the substrate 3 cannot take place any longer. Therefore, it is a serious disadvantage of the apparatus mentioned above that the product semiconductor films (semiconductor layers) cannot have a smoothly finished surface. This disadvantage is further aggravated by the fact that Ga·As particle flags formed by contact and reaction, in the gaseous atmosphere, of the reactants that have failed to arrive at the surface of the substrate 3 due to the above-mentioned thermal convection (arrows B) float in the gaseous atmosphere and deposit on the semiconductor film at random. Furthermore, in the above-mentioned apparatus, any change in the kind of feed gas is effected by operation of a plurality of valves 5, 6 and 7 for respective gas feeding pipes connected to the above-mentioned nozzle 4. For formation of a plurality of semiconductor layers differing in kind, frequent change-over operation of the valves 5, 6 and 7 is required. This disadvantageously means a low operation efficiency. It is a further problem that the compound or compounds used in the previous series of runs remain in the nozzle 4 and behave as impurities which make it difficult to obtain semiconductors of good quality.

Accordingly, it has been desired to provide an apparatus for producing good quality semiconductors having a smooth semiconductor layer surface efficiently by combining the advantages of the MBE process and those of the MOCVD process.

The present invention provides a modified semiconductor production apparatus provided with a vacuum chamber which can be evacuated to a high degree of vacuum, a substrate holder disposed in said vacuum chamber, reactant gas feeding means and a substrate heating means characterized in that at least one reaction chamber comprising a base, surrounding walls rising from the circumference of the base and a top plate capable of opening and closing the reaction space defined by the walls is provided within the vacuum chamber; the top plate is fitted with a holding means for holding at least one substrate so that the substrate remains in contact with the reaction space; the base of the reaction chamber is provided with reactant gas feeding means for feeding reactant gases toward the substrate held on the holding part; reactant gas exhaust ports are provided on the reaction chamber walls or between the walls and the top plate; and the a heating means is positioned and installed over the top plate of the reaction chamber.

In the accompanying drawings,
Fig. 1(a) illustrates, in vertical section, an embodiment of the semiconductor production apparatus according to the invention,
Fig.1(b) illustrates, in plan view, the heater of said apparatus,
Fig. 2 is an enlarged view of part of Fig. 1(a),
Fig. 3 illustrates, in perspective, the reaction chamber thereof,
Fig. 4 illustrates, in planar section, the apparatus inclusive of a substrate feeding apparatus,
Fig. 5 illustrates, in plan view, the state of distribution of nozzle openings and of feeding pipes in the reaction chamber,
Fig. 6 illustrates, in plan view, another embodiment of the invention, which is suited for continuous production of semiconductors,
Fig. 7 is a vertical sectional view of said embodiment as seen along A-A′ shown in Fig. 6,
Fig. 8 illustrates, in plan view, the rotating disc block used in said embodiment,
Fig. 9 illustrates a MESFET epitaxy layer deposition process,
Fig. 10 illustrates a HEMT epitaxy layer deposition process, and
Fig. 11 illustrates, in cross section, a conventional apparatus.

In semiconductor production apparatus according to the invention, the vacuum chamber is evacuated to a high degree of vacuum to increase the mean free path for reactant gas molecules and the gas molecules are allowed to collide against the substrate efficiently in the form of molecular beams and, at the same time, the reactant gases are fed from reactant gas feeding means to the reaction chamber newly provided in the vacuum chamber and smaller in capacity than the vacuum chamber, for semiconductor layer deposition on the substrate placed in said reaction chamber. As a result, the reactant gas utilization efficiency can be much increased. In said apparatus, the vacuum chamber is maintained at a high degree of vacuum and, therefore, even a Group III compound which is low in vapor pressure can be gasified there. Consequently, the use of a carrier gas for gasifying and carrying the Group III compound is no more necessary, and the quantity of waste gas to be treated for disposal becomes minimal. Furthermore, semiconductor layers with very good surface smoothness can be formed since the reactant gases fed into the reaction chamber are no more influenced by thermal convection and so forth because of such construction of the apparatus that the top plate, which is a constituent of the reaction chamber, holds the substrate, that the base of the reaction chamber is fitted with the reactant gas feeding means and that the heater is located over the top plate of the reaction chamber.

The following examples will illustrate the invention in more detail.

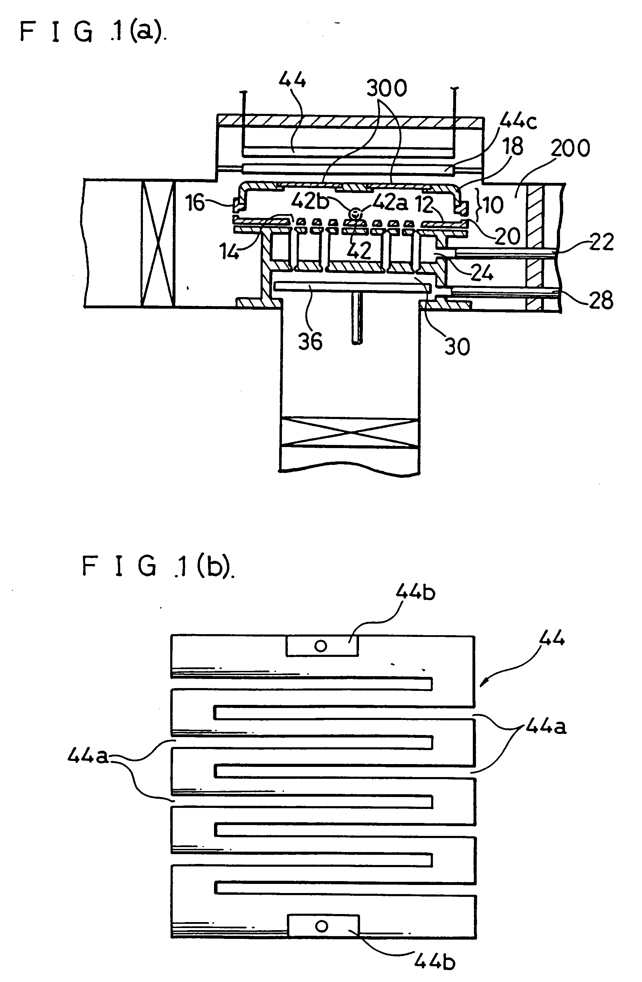

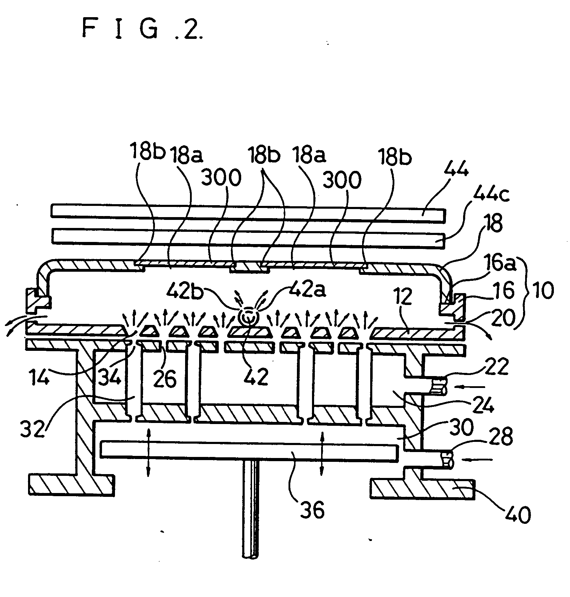

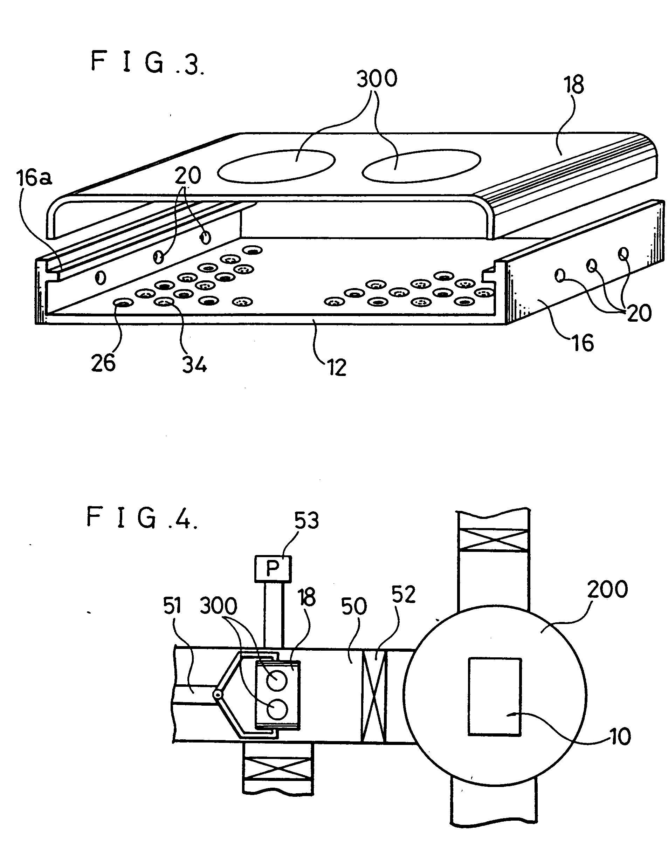

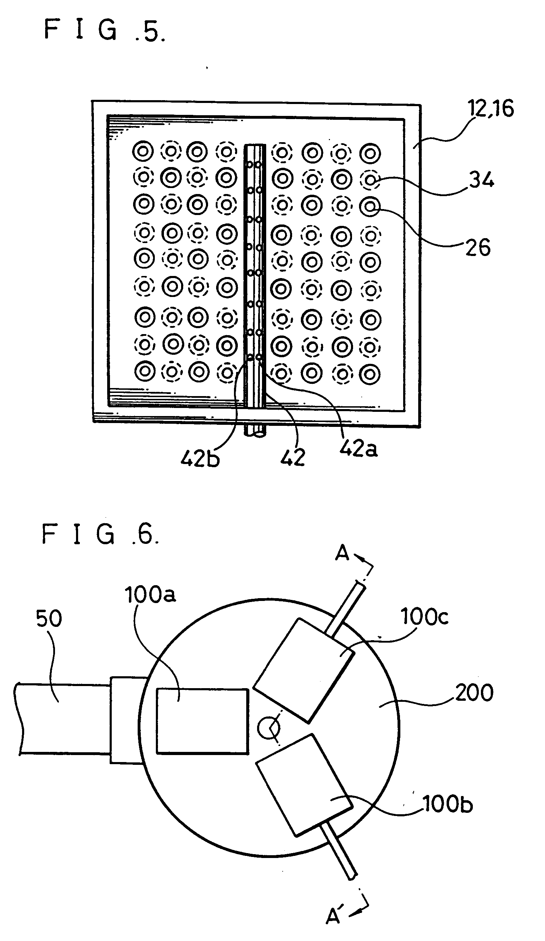

Figs.1-4 illustrate an embodiment of the semiconductor production apparatus according to the invention. In these figures, the reference numeral 200 indicates the vacuum chamber of a vacuum chemical epitaxy system. The vacuum chamber 200 has a reaction chamber 10 therein, which is formed by a tetragonal base plate 12, surrounding walls 16 rising from the circumference of said base plate and a top plate 18 placed, slidably in one direction, on the upper edges of the surrounding walls 16. The top plate 18 has, in the middle portion thereof, two openings 18a. A disc-form GaAs the middle portion thereof, two openings 18a. A disc-form GaAs substrate 300 of which the surface faces below is detachably mounted on the holding part 18b on the circumference of each opening 18a. The right and left (in the figures) ends of the top plate 18 are curved downward, and the curved portions are slidably supported on slideways 16a provided inwardly on the right and left (in the figures) opposed wall 16 out of the four surrounding walls 16, so that the top plate 18 can slide toward a substrate exchange chamber 50 (Fig. 4) connected to the vacuum chamber 200. Referring to Fig. 4, a magic hand 51 can move the top plate 18, with the curved portions thereof nipped by said hand, from the substrate exchange chamber 50 through a valve 52 to the vacuum chamber 200 and can place the top plate 18 just on the reaction chamber 10. A vacuum pump 53 evacuates the substrate exchange chamber 50 prior to opening of the valve 52 to a vacuum approximately equal to that in the vacuum chamber 200. The surrounding walls of the reaction chamber 10 have exhaust ports 20 at certain given intervals around the same for discharge of unreacted or excess reactant gas mixture from the reaction chamber into the vacuum chamber 10. The total area of these exhaust ports 20 is preferably about 4% of the surface area of the top plate 18 of the reaction chamber 10. The base plate 12 has nozzle openings 14 having a diameter of 3.2 mm, for instance, with the diameter being increased on the upper side, and perforated just below both substrates 300 and at regular intervals (e.g. 25.4 mm), said nozzle openings having a direction perpendicular to the substrate 300 and being in communication with openings 26 or 34 on the ceiling of a first mixing chamber 24 disposed below the reaction chamber 10. As shown in Fig. 5, the openings 26 are disposed alternately with the same number of the openings 34. Each opening 26 is in communication with the first mixing chamber 24, whereas each opening 34 is in communication with a second mixing chamber 30 via a duct 32 which passes through the first mixing chamber 24. The first mixing chamber 24 is in communication with a starting material inlet tube 22 passing through one side wall, as shown in Fig. 2. Said starting material inlet tube 22 serves for introducing into the first mixing chamber 24 of a Group III compound (reactant gases) such as trimethylgallium (TMGa) or triethylgallium (TEGa) or of an n-type or p-type dopant either alone or in admixture with such Group III compound. The compound or compounds, after uniform mixing in the first mixing chamber 24, are fed, via the openings 26 and nozzle openings 14, to the reaction chamber in a state of uniform distribution toward the respective substrates 300 positioned above the nozzle openings. The second mixing chamber 30 has an opening in the lower part, and an exhaust valve 36, suitably a poppet valve, is disposed displaceably in said opening for opening or closing said opening. Said second mixing chamber 30 is in communication, through one side wall thereof, with a starting material inlet tube 28. Through said inlet tube 28, an n-type or p-type dopant or a Group III compound such as triethylaluminum (TEA1) enters the second mixing chamber 30. The Group III compound, after mixing to a homogeneous state in the second mixing chamber 30 and the ducts 32, enters the reaction chamber in a state of uniform distribution via the openings 34 and the nozzle openings 14 toward the substrates 300. The ducts 32 mentioned above work as the reactant gas flow registance and give an effect of mixing to serve for improved mixing of reactant gases in the first mixing chamber 24. The first and second mixing chambers 24, 30 are made of a stainless steel block formed integrally and are supported by a stainless steel support member 40. As shown in Fig.5, a feeding tube 42 for feeding a Group V compound such as AsH₃ to the reaction chamber 10 is disposed on the base plate 12 in a position such that it splits the openings 26 and 34 into equal (in the figure, right and left) halves. Said feeding tube has a plurality of holes 42a and 42b at certain definite intervals and in two rows (right and left), whereby the Group V compound can be fed to the reaction chamber 10 in a uniformly distributed state. A heater 44 is disposed above the top plate 18 of the reaction chamber 10, with a leveling plate 44c located between said heater and said top plate. The substrates 300 are thus heated mainly by radiant heat from the above to a temperature sufficient for semiconductor compound deposition on the surface thereof without exposing the forming semiconductor layers to thermal convection and the like influences. As a result, semiconductor layers can deposit on the substrates 300 uniformly. As shown in Fig. 1 (b), the heater 44 may be made by cutting a carbon graphite sheet to make alternate stripe-form cuttings 44a, and fitting the sheet with electrodes 44b on both ends of the sheet. While uniform planar heating is possible with such heater 44 alone, the use of the heat leveling plate 44c disposed below the heater 44 can make the planar heating more uniform.

In operation for MESFET epitaxy layer deposition, the reaction chamber 10 is fitted with the top plate 18 with the substrates 300 (the surfaces face below respectively.) thereon, as shown in Fig. 1. Then, the vacuum chamber 200 is evacuated to a vacuum of 4,33 x 10⁻⁵Pa (10⁻⁷ torr) and the heater 44 is electrically loaded so that the heater 44 can generate heat and raise the atmospheric temperature to 650°C. In that state, the substrates 300 are heated for about 15 minutes. Thereafter, a Group III compound, such as trimethylgallium (TMGa) or triethylgallium (TEGa), is fed from the starting material inlet tube 22 of the reaction chamber 10 to the first mixing chamber 24 and mixed there uniformly and then enters the reaction chamber via the nozzle openings 14 in a uniformly distributed state toward the surface of the substrates 300. At the same time, a Group V compound, such as AsH₃ or an alkylarsine, for example triethylarsine (TEAs), is fed to the feeding tube 42. An excessive amount of the Group V compound enters the reaction chamber 10 through the holes 42a and 42b. As a result, the Group V compound thus fed to the reaction chamber 10 flows, together with the above-mentioned Group III compound (and so forth), dispersedly along the surface of the substrates 300 toward the exhaust ports 20. During the flow, AsH₃ or TEAs is thermally decomposed to give As₂, which, together with gallium from the above-mentioned gallium compound, comes into contact with the surface of the substrates 300 and deposits on said surface in the form of an undoped gallium arsenide (GaAs) layer or the like. The unreacted compounds that has not come into contact with the substrates 300 leave the reaction chamber via the exhaust ports 20 and enters the vacuum chamber 200, which they then leave laterally under the action of an exhaustion means. It is preferable to allow deposition of the above-mentioned GaAs layer at a growth rate of about 2 µm per hour and to a thickness of about 1000 nm (10⁴ Å). In this case, the concentration of impurity portion in said undoped GaAs layer should preferably be not higher than 1 x 10¹⁵ atoms per square centimeter. Then, an n-type dopant, either alone or in admixture with the above-mentioned Group III or V compound, is fed to the reaction chamber 10 from the second mixing chamber 30 so that an n-type active layer can deposit on the surface of said undoped GaAs layer. This n-type active layer is preferably caused to deposit at a growth rate of about 2 µm per hour and to a thickness of about 200 nm (2 x 10³ Å). A suitable n-type dopant concentration in said active layer is about 2 x 10¹⁷ atoms per square centimeter. Thereafter, all the gas supplies are discontinued and the system is maintained in that state for about 15 minutes. Then, the substrates 300 are cooled and taken out of the reaction chamber 10 (hence, from the vacuum chamber 200) in the following manner. Thus, the vacuum in the substrate exchange chamber 50 is increased to a level which is approximately equal to that in the vacuum chamber 200, the valve 52 is then opened, the magic hand 51 is stretched so as to hold the top plate 18 (with the substrates 300) of the reaction chamber 10 and then put back in that state, whereby the top plate 18 is slided off from the walls 16 of the reaction chamber 10 and received by the substrate exchange chamber 50. The substrates 300 taken out are fitted with signal source electrodes, drain electrodes and gate electrodes by known means. In this way, Group III-V compound semiconductors having a uniform MESFET semiconductor layer can be obtained.

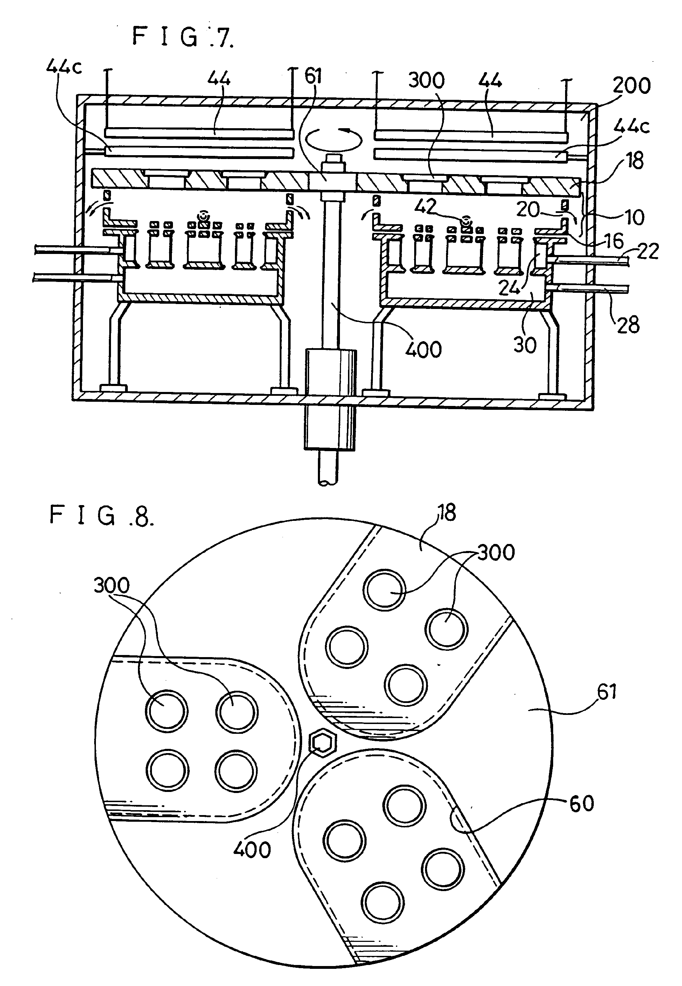

Figs. 6-8 illustrate another embodiment of the invention, which is suited for continuous semiconductor production. In this apparatus, vacuum chamber 200, which is round, is divided into three zones 100a, 100b and 100c and each zone has a reaction chamber 10 which is the same as that mentioned hereinabove. The top plate 18 of each reaction chamber 10 is mounted detachably on the corresponding arch-shaped cut made in a rotatable disc 61 (Fig. 8) approximately equal in size to the vacuum chamber 200. Thus, the top plate 18 is approximately equal in shape to the above-mentioned arch-shaped cut 60 and is supported detachably by the supporting part formed on the circumferential edge of said arch-shaped cut 60. The rotatable disc 61 with three top plates 18 is slowly rotated around a rotatable shaft 400 positioned at the center of the vacuum chamber 200 after each operational run in a manner such that the top plate 18 of one reaction chamber 10 is shifted to the position of the next reaction chamber 10. The surrounding walls 16 of said each reaction chamber 10 have exhaust ports 20 around the same at certain given intervals. The reaction chamber 10 in the zone 100a which is close to the substrate exchange chamber 50 serves for preheating the substrate 300, the reaction chamber 10 in the zone 100b serves for undoped layer growth, and the reaction chamber 10 in the zone 100c serves for n-type active layer growth.

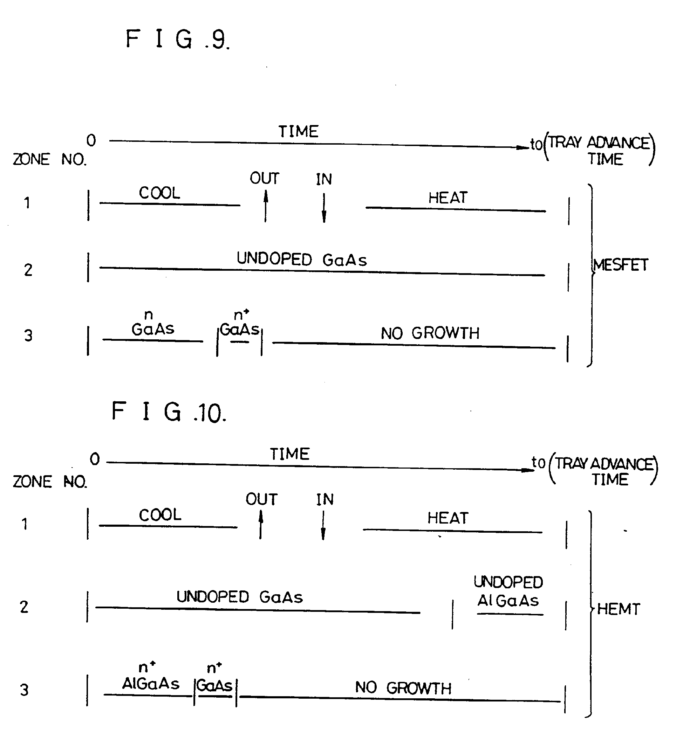

In operation, 1152 semiconductors can be produced weekly when four substrates 300 are placed, in the state that the surfaces respectively face downward, on each of the top plates 18 in the zones 100a, 100b and 100c and the apparatus is operated in a two-shift system a day. Referring to Fig. 9 (MESFET epitaxy layer deposition process flowchart) and Fig. 2, the mode of operation will be described in more detail. First, the vacuum chamber 200 is evacuated to a vacuum of 4,33 x 10⁻⁵Pa (10⁻⁷ torr) and the heater 44 is electrically loaded for heat generation to raise the atmosphere temperature to 650°C. In that state, the top plate 18 with the substrates 300 is mounted on that arch-shaped cut 60 of the rotating disc 61 which corresponds to the first zone by stretching the magic hand 51 from the substrate exchange chamber 50. The substrates 300 are heated there for about 15 minutes and then transferred to the reaction chamber 10 of the second zone 100b by rotating the rotating disc 61 together with said top plate 18 and substrates 300. In the reaction chamber 10 in the second zone, a Group III compound, such as trimethylgallium (TMGa) or triethylgallium (TEGa), is fed to the first mixing chamber 24, as mentioned above for the first apparatus. The uniformly mixed gas of said Group III compound then enters the reaction chamber in a uniformly distributed state through the nozzle openings 14 toward the substrates 300. At the same time, a Group V compound such as AsH₃ or an alkylarsine, for example triethylarsine (TEAs) is fed to the feeding tube 42 for feeding said compound in excess to the reaction chamber 10 via the holes 42a and 42b. An undoped gallium arsenide (GaAs) layer is thereby deposited on the surface of the substrate 300. After the above treatment, the substrates 300, together with the top plate 18, is transferred to the reaction chamber 10 in the third zone 100c. In this zone, an n-type dopant, together with a Group III compound, is fed to the reaction chamber 10 from the first mixing chamber 24, or the dopant alone is fed to the reaction chamber 10 from the second mixing chamber 30, to thereby cause deposition of an n-type active layer on the surface of the above-mentioned undoped GaAs layer. Thereafter, feeding of all the gases including the above-mentioned Group III compound is suspended, and the reaction chamber is maintained in that state for about 15 minutes. Then, the top plate 18 is further rotated such that the substrates 300 treated in the above manner return to the reaction chamber 10 in the first zone 100a. After cooling there, the substrates 300 are taken out therefrom together with the top plate 18 and transferred to the substrate exchange chamber 50 by means of the magic hand 51. This apparatus can produce semiconductors continuously by repeating the above series of operations. In this case, the above three treatments are performed simultaneously in the corresponding reaction chambers 10. The time required for such series of treatments amounts to about 1.5 hours, made up as follows: about 15 minutes each for heating and cooling in the first zone 100a, about 30 minutes for undoped layer growth in the second zone 100b, and about 15 minutes for n-type active layer growth and about 15 minutes of no growth period (without feeding of any gaseous compound) in the third zone 100c. Therefore, 1.5 hours is required for processing twelve substrates 300. Hence, when the apparatus is operated continuously by working in two shifts a day, it can produce 1152 semiconductors weekly.

Fig. 10 shows a HEMT epitaxy layer deposition process flowchart. According to this chart, HEMT epitaxy layers can be grown in the second and third zones 100b and 100c by feeding, in the same manner as mentioned above, an A1-containing Group III compound, such as triethylaluminum, from the second mixing chamber 30 (Fig. 7). In this case, the substrates 300 are first heated in the first zone 100a in the same manner as mentioned above. Then, in the second zone 100b, a GaAs layer having a dopant concentration of not more than 1 x 10¹⁵ atoms per square centimeter and a thickness of about 1000 nm (10⁴ Å) is caused to deposit by using gaseous Group III and Group V compounds and, further, an undoped A1_{z}Ga_{1-z}As layer is caused to deposit on the above-mentioned GaAs layer to a thickness of 3-10 nm (30-100 Å) by feeding an Al-containing compound from the second mixing chamber 30 in addition to the above-mentioned gas. In the third zone 100c, an n-type dopant is fed in addition to the above-mentioned gas for causing an n⁺-type Al_{z}Ga_{1-z}As layer to grow on the above-mentioned A1_{z}Ga_{1-z}As layer to a thickness of 50 nm (500 Å). In that case, the number z has a value of 0.1-0.9, preferably 0.2-0.3. Then, the exhaust valve (not shown) installed with a starting material inlet tube 28 for the second mixing chamber 30 is closed and the feeding of the Al-containing compound alone among the gas components is discontinued, so that an n-type GaAs layer containing the n-type dopant is caused to deposit to a thickness of about 100 nm (10³ Å). Thereafter, in the same manner as mentioned above, the substrates 300 having a semiconductor layer formed thereon are cooled in the first zone 100a, taken out of the semiconductor production apparatus and fitted with signal source electrodes and so forth. In this way, HEMT semiconductors can be produced. The time required in this case is substantially the same as mentioned above.

In the apparatus mentioned above, the distance from the nozzle openings 14 to the substrates 300 is adjusted such that said distance is shorter than the mean free path (average distance traveled by a gas molecule until it collides with another molecule) for gas molecules of the Group III compound in a vacuum state and that the state of dispersion of the compounds over the surface of the substrates 300 can become uniform. More detailedly, the substrates 300 are disposed at such positions where the circles formed at the ends of the inverse cones of dispersing upward of the Group III compound and so forth fed from the nozzle openings 14 intersect with one another and where the distribution state of gas molecules arriving at the substrates 300 and the collision velocity thereof are sufficient for deposition of the gas molecules on the surface of the substrates 300 at an appropriate rate. Alternatively, the vacuum in the vacuum chamber 200, the rate of feeding of the gaseous compound or compounds and/or the number, diameter and/or some other factor of the openings 26 and 34 and/or the nozzle openings 14 is adjusted depending on the predetermined fixed distance between the nozzle openings 14 and the substrates 300. Such measures should be taken so that semiconductor layers having a thickness within the range of a specified thickness ± 5%, more preferably within the range of a specified thickness ± 1%, can be obtained. Generally, the higher the temperature of the substrates 300, the more quickly the reaction proceeds in the formation of GaAs from TEGa and AsH₃, for instance. However, when the substrate temperature is excessively high, the material is re-evaporated from layers once formed, whereby the layer growth rate is decreased. Therefore, the temperature of the substrates 300 should preferably be adjusted within the range of 500-700°C, more preferably 600-650°C. The vacuum condition in the reaction chamber 10 should preferably be less than 1,33 x 10⁻⁴ Pa (10⁻⁶ torr). The relationships among various conditions, for example feed rates for TEGa, AsH₃, etc., temperature of substrates 300, and so forth may be described in terms of the following equations (1), (2) and (3): 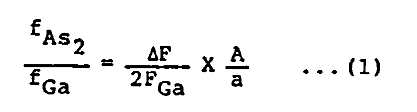 where "f" is the beam flux of the subscripted material, F is the flow rate, A is the deposition area and a is the area of the exhaust ports 20. This area a of exhaust ports 20 should preferably amount to about 4% of the deposition area A. When the area a exceeds 4% of A, the Group V compound is exhausted excessively, whereby the distribution state within the reaction chamber 10 becomes no more uniform. As a result, the uniformity of the semiconductor layers obtained will be inferior. When the a/A ratio is below 4%, the flow of the Group V compound from within the reaction chamber 10 to the exterior becomes worsened and the efficiency of utilization of the Group III compound is decreased. As a result, efficient semiconductor layer deposition will be effected any longer. The equation (1) indicates that the density ratio between As₂ and Ga is proportional to the product of the ratio between the deposition area A and the area a of exhaust ports 20 and the ratio between the flow rate ratio between AsH₃ and TEGa.${\text{λ = kTV}}_{\text{b}} {\text{/πd}}_{\text{a}} {\text{²V}}_{\text{h}} \text{P}$ where λ is the mean free path for the Group III compound, dₐ is the average diameter of the molecules colliding with the substrates 300, T is the temperature, V_{b} is the velocity of beam molecules of the Group III compound fed through the nozzle openings 14, and Vₕ is the velocity of molecules of the Group V compound heated in the vicinity of the substrates 300. An appropriate geometry of the reaction chamber 10 can be designed on the basis of this equation (2). It is important that the distance from the nozzle openings 14 to the substrates 300 should be similar than the mean free path λ for the Group III compound and at the same time such that the Group V compound can be distributed uniformly on the surface of the substrates 300.

The pressure drop within the reaction chamber 10 between the central portion thereof and the exhaust ports 20 should be smaller as compared with the difference in pressure between the inside of the reaction chamber 10 and the outside thereof across the exhaust ports 20. For instance, when the length of the reaction chamber 10 is equal to the width thereof, the ratio between the conductance Ca from the central part of the reaction chamber 10 to the side wall side and the conductance Co outside the reaction chamber 10 can be expressed by the following equation (3):${\text{C}}_{\text{a}} {\text{/C}}_{\text{o}} \text{= 4h²/a}$ where h is the nozzle opening 14 to substrate 300 distance, and a is the exhaust port 20 area. In this relation, the Ca/Co ratio should preferably amount to 4. In other words, the pressure variation across the reaction chamber 10 should preferably be not more than about 25%. Furthermore, the Group V compound should preferably be supplied in sufficient excess to render this pressure variation within the reaction chamber 10 insignificant. Even in that case, the consumption of the Group V compound can be reduced to about 1/20 as compared with the conventional MOCVD process.

As mentioned above, this apparatus for continuous production of semiconductors can perform different treatments in a continuous manner while transferring stepwise the substrate 300 to the reaction chamber 10 disposed in each of the three zones 100a, 100b and 100c resulting from division of the vacuum chamber 200 into three. Therefore, it can produce semiconductors very efficiently. Since each zone 100a, 100b, 100c has its reaction chamber 10 and the substrates 300 are treated in said reaction chamber 10, the reactant gases can be used effectively and, furthermore, different compounds may be used in the respective reaction chambers 10 in the zones 100a, 100b and 100c. Thus, the efficiency of reactant gas utilization can be improved and quality deterioration of semiconductor layers which may be caused by contamination of a compound with a different compound or compounds as impurities can be avoided or prevented.

In the above embodiment, it is also possible that each reaction chamber 10 have a cylindrical form and accordingly each top plate 18 have the corresponding circular form and that the top plates each can move independently to the next reaction chamber slowly and rotatedly around the central axis of the reaction chamber 10 system. This makes it easy to attain increased uniformity of semiconductor layers. While three reaction chambers 10 of the same geometry are used in the above embodiment, it is also possible to fabricate multilayer semiconductors by adding an additional reaction chamber or chambers and accordingly increasing the number of treatment steps. It is further possible to perform heating and cooling in separate chambers. The transfer of the substrates 300 to the next reaction chamber can be conducted not only by rotating the rotatable disc 61 with the top plates 18 mounted thereon, as in the above embodiment, but also by any other adequate means. For example, each base plate 12 with the surrounding walls 16 may be moved to the next reaction chamber position while the top plates 18 and mixing chambers are fixedly positioned. Furthermore, in one of possible modifications, the reaction chamber 10 for use in the first zone 100a may be lacking in nozzles and the like but is capable of heating and cooling alone, while the reaction chambers for use in the remaining zones 100b and 100c may have only one mixing chamber or three mixing chambers (when an additional mixing chamber is added below the second mixing chamber) depending on the treatments to be performed there. When, in the apparatus in the above embodiment and in the apparatus shown in Fig. 1, an additional mixing chamber is disposed, the exhaust valve 36 may be located either in the lowermost mixing chamber alone or in each of the mixing chambers. While, in both of said apparatus, the mixing chambers 24 and 30 are separated from each other and serve for feeding different starting material gases to the reaction chamber 10 via the nozzle openings 14 in communication with the respective mixing chambers, it is also possible to bring the mixing chambers 24 and 30 into communication with each other by means of holes or the like so that the starting material gases supplied from the starting material inlets 22 and 28 can be mixed in the mixing chamber 24 and then fed to the reaction chamber 10. It is further possible to provide the mixing chamber or chambers with a cooling jacket or the like to thereby cool the gaseous compound or compounds to an appropriate temperature by supplying cooling water to said jacket or the like. Said means serves for preventing excessive temperature rises in the gaseous compound or compounds and premature reactions of said compounds.

The apparatus in the foregoing embodiment and the apparatus shown in Fig. 1 each has two mixing chambers 24 and 30 for each reaction chamber 10, as mentioned above, and therefore can be used in a variety of modes because a plurality of different compounds can be fed through the respective nozzles. Furthermore, since the substrates 300 are heated from above by means of the heater 44 disposed over the top plate 18 while the gaseous compounds for semiconductor deposition are fed to the substrates 300 from below, adequate treatments can be realized and efficient deposition of good-quality semiconductor layers can be caused without any influence due to convectional gas flow resulting from heat generation by the heater 44. In addition, since the rate of compound flow within the reaction chamber is rendered constant as a result of exhaustion of unreacted gaseous compounds from the reaction chamber 10 via the exhaust ports 20 and since the feed tube 42 is disposed in a position which splits a plurality of nozzle openings 14, which are in communication with the mixing chambers 24 and 30, into equal halves, the Group V compound and so on can be fed to the surface of the substrates 300 in a uniformly mixed state, so that semiconductor layers of a Group III-V compound can be deposited uniformly. It is further possible for the apparatus of Fig. 1 to feed gaseous compounds to the substrates 300 intermittently since there is provided the exhaustion valve 36 in the second mixing chamber 30. The use of TEAs, which is relatively low in toxicity, as the Group V compound can facilitate post-reaction treatment thereof for disposal. The fact that no carrier gas is used minimizes the gas quantity required and this also facilitates the waste disposal treatment.

## Claims

1. Apparatus for semiconductor production comprising a vacuum chamber (200) which can be evacuated to a high degree of vacuum, a substrate holder disposed in the vacuum chamber, reactant gas feeding means and a substrate heating means, characterized in that at least one reaction chamber (10) comprising a base (12), surrounding walls (16) rising from the circumference of the base and a top plate (18) capable of opening and closing the reaction space defined by the walls is provided within the vacuum chamber; the top plate is fitted with holding means (18a,18b) for holding at least one substrate (300) so that the substrate remains in contact with the reaction space; the base of the reaction chamber is provided with reactant gas feeding means for feeding reactant gases toward the substrate held on the holding means; reactant gas exhaust ports (20) are provided on the reaction chamber walls or between the walls and the top plate; and the heating means (44,44c) is positioned and installed over the top plate of the reaction chamber.

2. Apparatus according to claim 1 characterized in that: the vacuum chamber (200) is divided into a plurality of zones (100a, 100b,100c); each zone containing a reaction chamber (10); and in that a top plate transfer means for transferring the top plates (18) of the reaction chambers stepwise to the respective neighbouring reaction chamber is provided in the vacuum chamber.

3. Apparatus according to claim 1 or 2, characterized in that the base (12) of the or each reaction chamber (10) is provided with a plurality of nozzle (14) openings for feeding reactant gases and a first (24) and a second (30) mixing chamber are disposed in a multistage manner below the reaction chamber, the mixing chambers being provided with means (22,28) for introducing different reactant gases respectively thereinto, the first mixing chamber having, on its ceiling, outlers (26) for introducing the reactant gas from the mixing chamber into the corresponding nozzle openings in the base of the reaction chamber, the second mixing chamber having, on its ceiling, outlets for introducing the reactant gas from the mixing chamber into the corresponding nozzle openings in the base of the reaction chamber through reactant gas flow routes (32,34) provided in the first mixing chamber.

4. Apparatus according to Claim 1, 2 or 3, characterized in that a feeding source (42) for feeding one reactant gas is provided on the base (12) of the or each reaction chamber (10) in such a manner that it divides the plurality of nozzle (14) openings for feeding other reactant gases disposed in the base of the reaction chamber into two regions each containing about half on the nozzle openings.

5. Apparatus according to any preceding claim in which the heating means comprises a heater (44) and a heat distributer disposed between the heater and the substrate (300).

6. Apparatus according to any preceding claim characterized in that the substrate holding means comprises an opening (18a) of slightly smaller diameter than that of the substrate (300) in the top plate (18) and a holding part (18b) on the circumference of each opening, the substrate being held on the holding part of the opening.

## Patentansprüche

1. Apparat zur Produktion von Halbleitern, umfassend eine Vakuumkammer (200), die zu einem hohen Vakuumgrad evakuierbar ist, einen in der Vakuumkammer angeordneten Substrathalter, Reaktionsgas-Zufuhrmittel und eine Substraterhitzungseinrichtung, dadurch gekennzeichnet, daß in der Vakuumkammer wenigstens eine Reaktionskammer (10) vorgesehen ist, die einen boden (12), umschließende Wände (16), die vom Umfang des bodens aufsteigen, und eine Deckelplatte (18) umfassen, die geeignet ist, den durch die Wände bestimmten Reaktionsraum zu öffnen und zu schließen, daß die Deckelplatte (18) mit Haltemitteln (18a, 18b) zum Halten wenigstens eines Substrates (300) versehen ist, so daß das Substrat mit dem Reaktionsraum in Kontakt bleibt, daß der boden der Reaktionskammer mit ReaktionsgasZufuhrmitteln versehen ist, um dem an den Haltemitteln gehaltenen Substrat Reaktionsgas zuzuführen, daß Reaktionsgas-Austrittsäffnungen (20) in den Reaktionskammerwänden oder zwischen den Wänden und der Deckelplatte vorgesehen sind, und daß die Erhitzungseinrichtung (44, 44c) über der Deckelplatte der Reaktionskammer angeordnet ist.

2. Apparat nach Anspruch 1, dadurch gekennzeichnet, daß die Vakuumkammer (200) in eine Mehrzahl von Zonen (100a, 100b, 100c) aufgeteilt ist, daß jede Zone eine Reaktionskammer (10) aufweist und daß eine Deckelplatten-Transporteinrichtung vorgesehen ist, um die Deckelplatten (18) der Reaktionskammern schrittweise zu der jeweiligen benachbarten, in der Rekationskammer vorgesehenen Reaktionskammer (10) weiterzutransportieren.

3. Apparat nach Anspruch 1 oder 2, dadurch gekennzeichnet, daß der boden (12) von der oder jeder Reaktionskammer (10) mit einer Mehrzahl von Düsenöffnungen (14) zur Zufuhr von Reaktionsgasen versehen ist und daß eine erste (24) und eine zweite (30) Mischkammer in einer mehrstufigen Art unter der Reaktionskammer angeordnet sind, daß die Mischkammern mit Mitteln (22, 28) zur Einleitung jeweils unterschiedlicher Gase versehen sind, daß die erste Mischkammer (24) an ihrer Decke Auslässe (26) aufweist, um Reaktionsgas aus der Mischkammer in die entsprechenden Düsenöffnungen im boden der Reaktionskammer einzuleiten, daß die zweite Mischkammer (30) an ihrer Decke Auslässe zur Einleitung von Reaktionsgas aus der Mischkammer in die entsprechenden Düsenöffnungen im boden der Reaktionskammer durch Reaktionsgas-Flußwege (32, 34), die in der ersten Mischkammer vorgesehen sind, aufweist.

4. Apparat nach Anspruch 1, 2 oder 3, dadurch gekennzeichnet, daß eine Zufuhrquelle (42) zur Zufuhr von Reaktionsgas am boden (12) von jeder Reaktionskammer (10) in der Weise vorgesehen ist, daß sie die im boden der Reaktionskammer vorgesehene Mehrzahl von Düsenöffnungen in zwei bereiche teilt, von denen jeder etwa die Hälfte der Düsenöffnungen enthält.

5. Apparat nach irgendeinem der vorhergehenden Ansprüche, dadurch gekennzeichnet, daß die Erhitzungseinrichtung einen Erhitzer (44) und einen zwischen dem Erhitzer und dem Substrat (300) angeordneten Hitzeverteiler umfaßt.

6. Apparat nach irgendeinem der vorhergehenden Ansprüche, dadurch gekennzeichnet, daß das Substrathaltemittel eine Öffnung (18a) in der Deckelplatte (18) von geringfügig kleinerem Durchmesser als dem des Substrates (300) und ein Halteteil (18b) am Umfang jeder Öffnung umfaßt, wobei das Substrat am Halteteil der Öffnung gehalten wird.

## Revendications

1. Appareil pour la production de semi-conducteurs comprenant une chambre de vide (200) pouvant être mise sous vide à un degré de vide élevé, un support de substrat disposé dans la chambre de vide, des moyens d'alimentation de gaz réactif et des moyens de chauffage du substrat, caractérisé en en ce que : au moins une chambre de réaction (10) comprenant une embase (12), des parois périphériques (16) s'élevant à partir de la circonférence de l'embase et une plaque de dessus (18) pouvant ouvrir et fermer l'espace de réaction défini par les parois est prévue à l'intérieur de la chambre de vide ; la plaque de dessus est dotée de moyens de support (18a, 18b) pour maintenir au moins un substrat (300) de sorte que le substrat reste en contact avec l'espace de réaction ; l'embase de la chambre de réaction est munie de moyens d'alimentation de gaz réactif pour alimenter ceux-ci vers le substrat maintenu sur les moyens de support ; des orifices d'échappement de gaz réactif (20) sont prévus sur les parois de la chambre de réaction ou entre les parois et la plaque de dessus ; et les moyens de chauffage (44, 44c) sont positionnés et montés par dessus la plaque de dessus de la chambre de réaction.

2. Appareil selon la revendication 1, caractérisé en ce que : la chambre de vide (200) est divisée en plusieurs zones (100a, 100b, 100c) ; chaque zone contenant une chambre de réaction (10) ; et en ce que des moyens de transfert de plaque de dessus destinés à transférer des plaques de dessus (18) des chambres de réaction progressivement sur la chambre de réaction avoisinante respective sont prévus dans la chambre de vide.

3. Appareil selon la revendication 1 ou 2, caractérisé en ce que l'embase (12) de la ou de chaque chambre de réaction (10) est munie de plusieurs ouvertures de buses (14) pour l'alimentation des gaz réactifs et une première (24) et une seconde (30) chambre de mélange sont disposées d'une manière multi-étagée au-dessous de la chambre de réaction, les chambres de mélange étant munies de moyens (22, 28) pour introduire respectivement dans celles-ci différents gaz réactifs, la première chambre de mélange ayant, sur son plafond, des sorties (26) pour introduire le gaz réactif depuis la chambre de mélange jusque dans les ouvertures de buses correspondantes dans l'embase de la chambre de réaction, la seconde chambre de mélange ayant, sur son plafond, des sorties pour l'introduction du gaz réactif à partir de la chambre de mélange jusque dans les ouvertures de buses correspondantes dans l'embase de la chambre de réaction par des passages d'écoulement du gaz réactif (32, 34) prévus dans la première chambre de mélange.

4. Appareil selon la revendication 1, 2 ou 3, caractérisé en ce qu'une source d'alimentation (42) destinée à alimenter un gaz réactif est prévu sur l'embase (12) de la ou de chaque chambre de réaction (10) de façon à diviser la pluralité d'ouvertures de buses (14) pour l'alimentation d'autres gaz réactifs disposées dans l'embase de la chambre de réaction en deux régions contenant chacune environ la moitié des ouvertures de buses.

5. Appareil selon l'une quelconque des revendications précédentes, dans lequel les moyens de chauffage comprennent un élément chauffant (44) et un élément répartiteur de chaleur disposés entre l'élément chauffant et le substrat (300).

6. Appareil selon l'une quelconque des revendications précédentes, caractérisé en ce que les moyens de support du substrat comprennent une ouverture (18a) de diamètre légèrement inférieur à celui du substrat (300) dans la plaque de dessus (18) et un élément de retenue (18b) sur la circonférence de chaque ouverture, le substrat étant maintenu sur la partie de retenue de l'ouverture.
